# EUROPÄISCHE PATENTSCHRIFT

(11) **EP 3 454 072 B1**
(45) Veröffentlichungstag und Bekanntmachung des Hinweises auf die Patenterteilung: **30.10.2024**
(21) Anmeldenummer: 17189538.6
(22) Anmeldetag: 06.09.2017
(51) Int. Cl.: G01R 33/58, G01R 33/48, G01R 33/56

(54) **JUSTIERUNG EINER MR-STEUERUNGSSEQUENZ FÜR EINE MAGNETRESONANZUNTERSUCHUNG EINES UNTERSUCHUNGSOBJEKTES**
ADJUSTMENT OF AN MR CONTROL SEQUENCE FOR A MAGNETIC RESONANCE EXAMINATION OF AN OBJECT TO BE EXAMINED
RÉGLAGE D'UNE SÉQUENCE DE COMMANDE MR POUR UN EXAMEN PAR RÉSONANCE MAGNÉTIQUE D'UN OBJET D'EXAMEN

(43) Veröffentlichungstag der Anmeldung: 13.03.2019
(73) Patentinhaber: Siemens Healthineers AG, 91301 Forchheim (DE)
(72) Erfinder: Hölscher, Uvo, 91052 Erlangen (DE)
(74) Vertreter: Siemens Healthineers Patent Attorneys

(56) Entgegenhaltungen:
- DE-A1- 102014 216 612
- DE-A1- 102015 200 695
- DE-B3- 102005 061 567
- US-A- 6 091 242
- US-A1- 2012 119 740
- US-A1- 2013 249 552

## Beschreibung

Die Erfindung betrifft ein Verfahren, ein Magnetresonanzgerät, ein Computerprogrammprodukt sowie einen elektronisch lesbaren Datenträger zu einer Justierung einer MR-Steuerungssequenz.

In einem Magnetresonanzgerät wird üblicherweise der zu untersuchende Körper eines Untersuchungsobjektes, insbesondere eines Patienten, mit Hilfe eines Hauptmagneten einem relativ hohen Hauptmagnetfeld, beispielsweise von 1,5 oder 3 oder 7 Tesla, ausgesetzt. Zusätzlich werden mit Hilfe einer Gradientenspuleneinheit Gradientenpulse ausgespielt. Die Gradientenpulse werden zur Ortskodierung eingesetzt. Über eine Hochfrequenzantenneneinheit werden dann mittels geeigneter Antenneneinrichtungen hochfrequente Hochfrequenz-Pulse, beispielsweise Anregungspulse, ausgesendet, was dazu führt, dass durch diese Hochfrequenz-Pulse resonant angeregte Kernspins bestimmter Atome um einen definierten Flipwinkel gegenüber den Magnetfeldlinien des Hauptmagnetfelds verkippt werden. Bei der Relaxation der Kernspins werden Hochfrequenz-Signale, so genannte Magnetresonanz-Signale (MR-Signale), abgestrahlt, die mittels geeigneter Hochfrequenzantennen empfangen und dann weiterverarbeitet werden. Aus den so akquirierten Rohdaten, also den MR-Signalen, können schließlich die gewünschten Bilddaten rekonstruiert werden. Für eine bestimmte Messung ist daher eine bestimmte Magnetresonanz-Steuerungssequenz (MR-Steuerungssequenz), auch Pulssequenz genannt, auszusenden, welche aus einer Folge von Hochfrequenz-Pulsen, beispielsweise Anregungspulsen und Refokussierungspulsen, sowie passend dazu koordiniert auszusendenden Gradientenpulsen in verschiedenen Gradientenachsen entlang verschiedener Raumrichtungen besteht. Zeitlich passend hierzu werden Auslesefenster gesetzt, welche die Zeiträume vorgeben, in denen die induzierten MR-Signale erfasst werden. Im Rahmen einer Magnetresonanzuntersuchung wird eine derartige MR-Steuerungssequenz ausgespielt, also die Hochfrequenz-Pulse und Gradientenpulse in einer definierten zeitlichen Abfolge ausgegeben und MR-Signale erfasst.

Die Intensität von MR-Signalen ist abhängig von der Umgebung der Kernspins, insbesondere der Moleküle, welche die Kernspins umfassen. Dadurch entsteht ein Kontrast in den rekonstruierten Bilddaten, wobei Fett beispielsweise eine andere Signalintensität aufweist als Wasser, was beispielsweise in Muskelgewebe überwiegt. Die Unterdrückung des Fettsignals, auch Fettsättigung genannt, ist in der Magnetresonanzbildgebung eine übliche Technik. Dabei kann die Fettsättigung spektral erfolgen, wobei die chemische Verschiebung zwischen Kernspins in Fett und Kernspins in Wasser ausgenutzt wird: Kernspins in Fett und Kernspins in Wasser weisen eine unterschiedliche Resonanzfrequenz, also Larmorfrequenz in Bezug auf die Stärke des Hauptmagnetfeldes, auf. Es wird zunächst ein Sättigungs-Hochfrequenz-Puls mit geringer Frequenzbandbreite zur resonanten Anregung der Kernspins in Fett ausgespielt, welche Kernspins in Fett dephasieren, bevor Hochfrequenz-Pulse und Gradientenpulse zur Erzeugung der MR-Signale ausgespielt werden. Die Sättigungs-Hochfrequenz-Pulse weisen ein derartiges Frequenzband auf, dass Kernspins in Wasser nicht angeregt werden. Zu den MR-Signalen für die Bildgebung tragen dann nur Kernspins bei, die außerhalb des Frequenzbandes der Sättigungs-Hochfrequenz-Pulse liegen. Alternativ kann Fettsättigung auch mittels Inversion erfolgen. Dabei wird zunächst ein Hochfrequenz-Puls zur Inversion ausgespielt und die Hochfrequenz-Pulse und Gradientenpulse zur Erzeugung der MR-Signale folgen nach einer definierten Inversionszeit, welche Inversionszeit die Zeitdauer zwischen dem Hochfrequenz-Puls zur Inversion und den Hochfrequenz-Pulsen und Gradientenpulsen zur Erzeugung der MR-Signale angibt. Der Hochfrequenz-Puls zur Inversion kann chemisch selektiv sein. Hierbei wird die Inversionszeit typischerweise derart gewählt, dass die Magnetisierung der Kernspins in Fett zum Zeitpunkt der Bildgebung sich im Nulldurchgang befindet und daher nicht zum MR-Signal beiträgt.

Eine Anpassung der Hochfrequenz-Pulse einer MR-Steuerungssequenz an das Untersuchungsobjekt und den Untersuchungsbereich ist hinsichtlich ihrer Frequenz und Amplitude erforderlich. Dies erfolgt bislang anhand einer herkömmlichen Justierung zur Bestimmung einer Referenzspannung und einer Referenzfrequenz. Zunächst wird herkömmlich ein Frequenzspektrum der Larmorfrequenzen der zumindest vom Untersuchungsbereich umfassten Kernspins gemessen. Das Frequenzspektrum weist typischerweise einen dominanten Peak auf, welcher aus den Kernspins umgeben von Wasser resultiert. Dessen zugeordnete Frequenz wird typischerweise für die Hochfrequenz-Pulse zur Erzeugung der MR-Signale, also als Referenzfrequenz, verwendet. Aus dieser Referenzfrequenz und der chemischen Verschiebung wird für die spektrale Fettsättigung für den Sättigungs-Hochfrequenz-Puls eine Referenzfrequenz berechnet. Die Referenzspannung gibt die elektrische Spannung an, welche zur Ansteuerung der Hochfrequenzantenneneinheit durch die Hochfrequenzantennensteuereinheit für die Erzeugung eines definierten Flipwinkels eines Kernspins erforderlich ist. Die Justierung der Referenzspannung erfolgt typischerweise gemäß einer Bestimmung einer Abhängigkeit des von einem Hochfrequenz-Puls erzeugten Flipwinkels eines Kernspins von der Spannung, mit welcher die Hochfrequenzantenneneinheit durch die Hochfrequenzantennensteuereinheit angesteuert wird. Herkömmlich wird dabei der mittlere Flipwinkel innerhalb eines definierten Volumens umfassend den gesamten Untersuchungsbereich betrachtet.

US 6 091 242 A offenbart ein Magnetresonanzgerät und ein Verfahren zu einer Bestimmung der Resonanzfrequenzen von Wasser und von Fett. US 2013/249552 A1 offenbart ein Verfahren zu einer Bestimmung einer Resonanzfrequenz anhand eines Frequenzspektrums.

Der Erfindung liegt die Aufgabe zugrunde, ein besonders genaues Verfahren zu einer Justierung einer MR-Steuerungssequenz anzugeben. Die Aufgabe wird durch die Merkmale der unabhängigen Ansprüche gelöst. Vorteilhafte Ausgestaltungen sind in den Unteransprüchen beschrieben.

Erfindungsgemäß wird ein Verfahren zu einer Justierung einer MR-Steuerungssequenz nach Anspruch 1 bereitgestellt.

Eine MR-Steuerungssequenz umfasst typischerweise Hochfrequenz-Pulse, welche Kernspins verschiedenartig modulieren und dadurch MR-Signale mit bestimmten Eigenschaften erzeugen. So gibt es beispielsweise die folgenden Pulsarten für Hochfrequenz-Pulse: Anregungspulse, Refokussierungspulse, Präparationspulse. Diese Aufzählung für Pulsarten ist nicht abschließend und weitere Pulsarten sind denkbar. Ein Anregungspuls verkippt beispielsweise Kernspins um einen definierten Flipwinkel gegenüber den Magnetfeldlinien des Hauptmagnetfelds. Ein Refokussierungspuls kann beispielsweise einen zu den Magnetfeldlinien des Hauptmagnetfelds senkrechten Anteil von Kernspins um 180° drehen. Ein Präparationspuls kann vor einem Anregungspuls eine Modulation, gegebenenfalls selektive Modulation bestimmter Kernspins, bewirken. Der erste Hochfrequenz-Puls und der zweite Hochfrequenz-Puls unterscheiden sich typischerweise voneinander. Der erste Hochfrequenz-Puls und der zweite Hochfrequenz-Puls können verschiedenen Pulsarten angehören. Der erste Hochfrequenz-Puls und der zweite Hochfrequenz-Puls können für voneinander verschiedene Teilbereiche des Untersuchungsbereiches vorgesehen sein. Der erste Hochfrequenz-Puls und der zweite Hochfrequenz-Puls sind typischerweise voneinander unabhängig. Der erste Hochfrequenz-Puls und der zweite Hochfrequenz-Puls gehören vorzugsweise verschiedenen Modulen der MR-Steuerungssequenz an. Hochfrequenz-Pulse weisen eine Frequenzbandbreite um eine Grundfrequenz auf und werden demnach in einem Frequenzband, definiert durch die Grundfrequenz und die Frequenzbandbreite, emittiert. Die Grundfrequenz entspricht der Frequenz des Hochfrequenz-Pulses, also der Trägerfrequenz. Ein Hochfrequenz-Puls bewirkt eine resonante Anregung eines Stoffes, sofern die Larmorfrequenz eines vom Stoff umfassten Kernspins der Frequenz des Hochfrequenz-Pulses, insbesondere an der Position des Kernspins, entspricht. Ein Hochfrequenz-Puls kann eine Anregung eines Stoffes bewirken, sofern die Larmorfrequenz eines vom Stoff umfassten Kernspins vom Frequenzband des Hochfrequenz-Pulses umfasst wird.

Ein Stoff kann beispielsweise ein Molekül, eine Zusammensetzung verschiedener Moleküle, und/oder ein Gewebe sein. Ein Stoff kann auch eine weitere Struktur sein, die hier nicht explizit genannt wird, und ist nicht auf die genannten Beispiele beschränkt. Der erste Stoff und der zweite Stoff sind voneinander verschieden.

Die selektive Anregung des zweiten Stoffes umfasst die resonante Anregung des zweiten Stoffes. Der erste Stoff wird vorzugsweise von der resonanten Anregung ausgeschlossen. Bevorzugt werden weitere vom zweiten Stoff verschiedene Stoffe, besonders bevorzugt alle vom zweiten Stoff verschiedene Stoffe, von der resonanten Anregung ausgeschlossen. Der erste Stoff wird bei der selektiven Anregung des zweiten Stoffes vorzugsweise nicht angeregt, insbesondere nicht resonant angeregt. Die selektive Anregung des ersten Stoffes umfasst typischerweise die resonante Anregung des ersten Stoffes. Der zweite Stoff wird vorzugsweise von der resonanten Anregung ausgeschlossen. Bevorzugt werden weitere vom ersten Stoff verschiedene Stoffe, besonders bevorzugt alle vom ersten Stoff verschiedene Stoffe, von der resonanten Anregung ausgeschlossen. Der zweite Stoff wird bei der selektiven Anregung des ersten Stoffes vorzugsweise nicht angeregt, insbesondere nicht resonant angeregt. Vorzugsweise erfolgt die selektive Anregung chemisch selektiv, also spektral selektiv, indem die Grundfrequenz und/oder die Bandbreite der Hochfrequenz-Pulse entsprechend gewählt werden. Die selektive Anregung kann auch mittels Inversion erfolgen. Zur selektiven Anregung kann ein Binomialpuls verwendet werden. Die Bestimmung eines Referenzwertes umfassend eine selektive Anregung kann auch eine Messung umfassend mehrere Hochfrequenz-Pulse zur selektiven Anregung umfassen, wobei Hochfrequenz-Pulse vorzugsweise die gleiche selektive Eigenschaft aufweisen.

Von einem Teilbereich des Untersuchungsobjektes, dem Untersuchungsbereich, sollen typischerweise im Rahmen der Magnetresonanzuntersuchung Bilddaten erzeugt werden. Das Untersuchungsobjekt ist typischerweise ein Patient. Der Untersuchungsbereich umfasst typischerweise einen Ausschnitt des Untersuchungsobjektes.

Ein Referenzwert umfasst typischerweise zumindest einen Parameter, welcher beim Ausspielen eines Hochfrequenz-Pulses berücksichtigt werden kann. Ein Hochfrequenz-Puls wird typischerweise durch eine Vielzahl an Parametern definiert. Ein Großteil dieser Vielzahl an Parametern für einen von einer MR-Steuerungssequenz umfassten Hochfrequenz-Puls ist typischerweise durch die MR-Steuerungssequenz gegeben. Dies kann beispielsweise die Dauer und/oder die Form der Einhüllenden des Hochfrequenz-Pulses sein. Eine Magnetresonanzuntersuchung erfordert typischerweise eine Anpassung zumindest eines Parameters an das Untersuchungsobjekt und/oder an den Untersuchungsbereich, welcher im Rahmen einer Justierung zu bestimmen ist. Ein Referenzwert umfasst typischerweise einen Parameter für einen Hochfrequenz-Puls, welcher Parameter vom Untersuchungsobjekt und/oder vom Untersuchungsbereich abhängig ist. Ein Referenzwert umfasst typischerweise einen Parameter für einen Hochfrequenz-Puls, welcher in der MR-Steuerungssequenz als Variable hinterlegt ist. Der erste Referenzwert umfasst eine Grundfrequenz und/oder ein Maß zur Skalierung einer Amplitude für den ersten Hochfrequenz-Puls. Der zweite Referenzwert umfasst eine Grundfrequenz und/oder ein Maß zur Skalierung einer Amplitude für den zweiten Hochfrequenz-Puls.

Eine Zuordnung eines Referenzwertes zu einem Hochfrequenz-Puls bewirkt eine Verknüpfung des Referenzwertes mit dem Hochfrequenz-Puls. Beim Ausspielen der MR-Steuerungssequenz umfassend den Hochfrequenz-Puls wird typischerweise der Referenzwert als zumindest ein Parameter für den Hochfrequenz-Puls berücksichtigt.

Das erfindungsgemäße Verfahren sieht demnach vor, dass für zumindest zwei voneinander verschiedene Stoffe und für zumindest zwei voneinander verschiedene Hochfrequenz-Pulse voneinander unabhängige Referenzwerte bestimmt werden. Es wurde im Rahmen dieser Erfindung erkannt, dass das herkömmliche Verfahren zur Justierung die Verschiedenheit von Stoffen wie beispielsweise Fett und Wasser nur mittels eines fixen Wertes für die chemische Verschiebung berücksichtigt. Insbesondere die selektive Anregung des ersten Stoffes und/oder des zweiten Stoffes ermöglicht eine genauere Bestimmung von zumindest einer Eigenschaft des ersten Stoffes und/oder des zweiten Stoffes. Eine Eigenschaft kann beispielsweise die Larmorfrequenz der Kernspins des ersten Stoffes und/oder zweiten Stoffes sein. Eine Eigenschaft kann beispielsweise die Abhängigkeit des von einem Hochfrequenz-Puls erzeugten Flipwinkels der Kernspins des ersten Stoffes und/oder zweiten Stoffes von der elektrischen Spannung, mit welcher die Hochfrequenzantenneneinheit durch die Hochfrequenzantennensteuereinheit angesteuert wird, sein. Dadurch kann die Bestimmung der Referenzwerte besonders genau erfolgen und die Justierung der MR-Steuerungssequenz kann besonders exakt ausgeführt werden. Insbesondere kann der Einfluss einer ungleichmäßigen räumlichen Verteilung des ersten Stoffes und des zweiten Stoffes ermittelt und/oder kompensiert werden.

Das erfindungsgemäße Verfahren ermöglicht demnach eine Verwendung unterschiedlicher Referenzwerte für unterschiedliche Stoffe. Die selektive Anregung zumindest eines Stoffes ermöglicht eine Bestimmung eines Referenzwertes, welcher zumindest teilweise unabhängig von einem für den gesamten Untersuchungsbereich gültigen Referenzwert ist. Dies ist insbesondere für Präparationspulse vorteilhaft, welche Präparationspulse einen bestimmten, typischerweise von Wasser verschiedenen Stoff modulieren. Ist der zweite Hochfrequenz-Puls ein Präparationspuls, so erfolgt vorzugsweise eine Bestimmung des zweiten Referenzwertes durch selektive Anregung des zweiten Stoffes. Dadurch kann bei der Bestimmung des zweiten Referenzwertes beispielsweise die räumliche Verteilung, die Larmorfrequenz und/oder die tatsächliche Abhängigkeit des aufgrund einer elektrischen Spannung, mit welcher die Hochfrequenzantenneneinheit durch die Hochfrequenzantennensteuereinheit angesteuert wird, induzierten Flipwinkels eines Kernspins des zweiten Stoffes berücksichtigt werden.

Die justierte MR-Steuerungssequenz wird vorzugsweise dem Magnetresonanzgerät und/oder dessen Steuerungseinheit bereitgestellt. Das Magnetresonanzgerät ist typischerweise dazu ausgebildet, die justierte MR-Steuerungssequenz auszuspielen. Durch das optionale Ausspielen der justierten MR-Steuerungssequenz erfolgt die Aufnahme von MR-Signalen des Untersuchungsbereiches des Untersuchungsobjektes, welche zu Bilddaten rekonstruiert werden können. Die Bilddaten, welche auf der justierten MR-Steuerungssequenz basieren, weisen typischerweise eine höhere Qualität und/oder Homogenität als Bilddaten auf, welche auf einer MR-Steuerungssequenz mit einer herkömmlichen Justierung basieren.

Eine Ausführungsform des Verfahrens sieht vor, dass das Verfahren einen weiteren Verfahrensschritt umfasst, gemäß welchem die Bestimmung eines Frequenzspektrums von vom Untersuchungsbereich umfasster Stoffe erfolgt, wobei das Frequenzspektrum bei der Bestimmung des ersten Referenzwertes und/oder des zweiten Referenzwertes berücksichtigt wird. Ebenso erfolgt im Rahmen dieses Verfahrensschrittes vorzugsweise eine herkömmliche Justierung der Referenzspannung über zumindest den Untersuchungsbereich.

Bei diesem Verfahrensschritt wird vorzugsweise das Frequenzspektrum der Larmorfrequenzen der zumindest vom Untersuchungsbereich umfassten Kernspins gemessen. Das Frequenzspektrum gibt typischerweise abhängig von der Frequenz die Signalintensität im Untersuchungsbereich an. Da die Larmorfrequenz von Kernspins von dem die Kernspins umgebenden Stoff abhängt, liegt eine spektrale Verteilung der Signalintensität vor. Die Larmorfrequenz ergibt sich aus dem gyromagnetischen Verhältnis des Kernspins und der Stärke des den Kernspin umgebenden Magnetfeldes. Das den Kernspin umgebende Magnetfeld resultiert überwiegend aus dem Hauptmagnetfeld, welches jedoch aufgrund der chemischen Umgebung des Kernspins, insbesondere des den Kernspin umgebenden Stoffes, moduliert wird. Die Modulation wird anhand der chemischen Verschiebung quantifiziert, welche beispielsweise zwischen Fett und Wasser in etwa 3,4 ppm beträgt.

Gemäß dieser Ausführungsform ist der Verfahrensschritt zur Bestimmung eines Frequenzspektrums vorzugsweise Ausgangspunkt für zumindest eine weitere Messung, insbesondere für die selektive Anregung des ersten und/oder der zweiten Stoffes. Basierend auf dem Frequenzspektrum kann beispielsweise ein Näherungswert für die Larmorfrequenz des ersten Stoffes und/oder zweiten Stoffes ermittelt werden. Dabei können die Larmorfrequenzen beider Stoffe basierend auf einer Analyse des Verlaufes des Frequenzspektrums erfolgen, vorzugsweise unter Ausschluss der Berücksichtigung einer bekannten chemischen Verschiebung zwischen dem ersten Stoff und dem zweiten Stoff. Vielmehr kann anhand einer bekannten chemischen Verschiebung zwischen dem ersten Stoff und dem zweiten Stoff das Ergebnis für die Larmorfrequenzen beider Stoffe basierend auf einer Analyse des Verlaufes des Frequenzspektrums kontrolliert werden.

Der Näherungswert für die Larmorfrequenz des ersten Stoffes und/oder zweiten Stoffes kann bei der selektiven Anregung des zweiten Stoffes als Grundfrequenz eines Anregungspulses verwendet werden, wobei mittels der selektiven Anregung des ersten Stoffes und/oder zweiten Stoffes weitere Eigenschaften des ersten Stoffes und/oder zweiten Stoffes ermittelt werden können. Beispielsweise kann mittels der selektiven Anregung des ersten Stoffes und/oder zweiten Stoffes ein Frequenzspektrum ausschließlich des ersten Stoffes und/oder zweiten Stoffes ausgeführt werden. Dadurch kann die Larmorfrequenz des ersten Stoffes und/oder zweiten Stoffes besonders genau bestimmt werden. Zudem kann basierend auf einer selektiven Anregung des ersten Stoffes und/oder zweiten Stoffes eine Justierung der Referenzspannung für den ersten Stoff und/oder zweiten Stoff erfolgen. Dadurch kann der erste Referenzwert für den ersten Stoff und der zweite Referenzwert für den zweiten Stoff besonders genau bestimmt werden. Diese Ausführungsform ermöglicht demnach eine besonders effiziente und genaue Bestimmung des ersten Referenzwertes und des zweiten Referenzwertes. Dies resultiert vorzugsweise in einer besonders kompakten Justierung der MR-Steuerungssequenz.

Eine Ausführungsform des Verfahrens sieht vor, dass das Verfahren einen zusätzlichen Verfahrensschritt umfasst, gemäß welchem eine Bestimmung eines allgemeinen Referenzwertes für von der MR-Steuerungssequenz umfasste Hochfrequenz-Pulse für den Untersuchungsbereich erfolgt, wobei der allgemeine Referenzwert bei der Bestimmung des ersten Referenzwertes und/oder des zweiten Referenzwertes berücksichtigt wird.

Der allgemeine Referenzwert ist typischerweise für den gesamten Untersuchungsbereich gültig und/oder einheitlich. Der allgemeine Referenzwert umfasst vorzugsweise eine Referenzspannung, welche mittels herkömmlicher Justierung in dem zusätzlichen Verfahrensschritt ermittelt wurde. Der allgemeine Referenzwert ist gemäß dieser Ausführungsform typischerweise ein Näherungswert für den gesamten Untersuchungsbereich, welcher im weiteren Verlauf des Verfahrens hinsichtlich des ersten Stoffes und/oder des zweiten Stoffes und/oder des ersten Hochfrequenz-Pulses und/oder des zweiten Hochfrequenz-Pulses angepasst werden kann.

Der Vorteil dieser Ausführungsform liegt darin, dass der allgemeine Referenzwert eine Näherung für den ersten Referenzwert und/oder den zweiten Referenzwert angibt, welcher gemäß dieser Ausführungsform des erfindungsgemäßen Verfahrens detailliert an einzelne Stoffe und/oder Hochfrequenz-Pulse angepasst werden kann. Dadurch kann die Justierung besonders effizient erfolgen.

Das erfindungsgemäße Verfahren sieht vor, dass bei der Bestimmung des zweiten Referenzwertes eine räumliche Verteilung des zweiten Stoffes und eine räumliche Verteilung eines B0-Feldes und/oder eines B1-Feldes berücksichtigt wird.

Eine räumliche Verteilung eines Stoffes gibt räumlich aufgelöst die Positionen des Untersuchungsbereiches an, an welchen Positionen der Stoff vorhanden ist. Die räumliche Verteilung eines Stoffes kann beispielsweise anhand einer Segmentierung des Stoffes in bereits vorhandenen Bilddaten und/oder anhand einer Selektion durch einen Benutzer bestimmt werden.

Die räumliche Verteilung eines Stoffes kann auch im Rahmen der Bestimmung eines Messwertes bestimmt werden. Erfindungsgemäß wird die räumliche Verteilung eines Stoffes mittels einer Messung umfassend eine selektive Anregung des Stoffes ermittelt.

Die Messung kann beispielsweise eine Messung zur Aufnahme von MR-Signalen sein, welche MR-Signale zu Bilddaten rekonstruiert werden können, wobei die dabei verwendeten Hochfrequenz-Pulse den Stoff selektiv anregen. Die daraus resultierenden Bilddaten visualisieren vorzugsweise nur den Stoff, welcher selektiv angeregt wurde. Die daraus resultierenden Bilddaten weisen vorzugsweise eine geringere Auflösung auf als Bilddaten, welche mit der justierten MR-Steuerungssequenz erzeugt werden. Die daraus resultierenden Bilddaten geben typischerweise die räumliche Verteilung des Stoffes wieder.

Das Hauptmagnetfeld, auch als B0-Feld bezeichnet, und/oder das durch einen Hochfrequenz-Puls erzeugte B1-Feld ist innerhalb des Untersuchungsbereiches typischerweise nicht homogen. Betrachtet man die räumliche Verteilung derartiger Felder, so ist diese typischerweise nicht gleichmäßig. Im Rahmen einer Justierung einer MR-Steuerungssequenz wird typischerweise die räumliche Verteilung des B0-Feldes und/oder des B1-Feldes bestimmt. Basierend auf dem mittleren B1-Feld wird typischerweise die Referenzspannung für alle von der MR-Steuerungssequenz umfassten Hochfrequenz-Pulse bestimmt.

Das erfindungsgemäße Verfahren ermöglicht eine Bestimmung eines Referenzwertes für einen Stoff abhängig von dessen räumlicher Verteilung. Erfindungsgemäß wird bei der Bestimmung eines Referenzwertes für einen Stoff zusätzlich zu dessen räumlicher Verteilung die räumliche Verteilung des B0-Feldes und/oder B1-Feldes berücksichtigt. So kann beispielsweise bei der Bestimmung einer Referenzspannung als Referenzwert die räumliche Verteilung des B1-Feldes berücksichtigt werden und die Referenzspannung basierend auf dem Teilbereich des B1-Feldes berechnet werden, welcher Teilbereich mit der räumlichen Verteilung des Stoffes überlappt. Ebenso kann bei der Bestimmung einer Grundfrequenz als Referenzwert zusätzlich zur Larmorfrequenz des Stoffes die räumliche Verteilung des B0-Feldes berücksichtigt werden.

Das erfindungsgemäße Verfahren ermöglicht eine besonders genaue Bestimmung von Referenzwerten für verschiedene Stoffe. Das erfindungsgemäße Verfahren ermöglicht die Berücksichtigung weiterer Parameter, welche vom Untersuchungsobjekt und/oder vom Untersuchungsbereich und/oder vom Magnetresonanzgerät anhängen. B1-Felder sind insbesondere bei Kugelformen und/oder Ellipsen, wie beispielsweise bei einem Kopf und/oder Körperstamm, inhomogen, da sie B1-Felder in der Mitte der Form verstärken und am Rand abschwächen. Da beispielsweise Fett häufig am Rand einer Körperform auftritt, ist eine Berücksichtigung der räumlichen Verteilung von Fett und des B1-Feldes besonders vorteilhaft.

Eine Ausführungsform des Verfahrens sieht vor, dass der erste Hochfrequenz-Puls zur Erzeugung eines MR-Signals und der zweite Hochfrequenz-Puls zur Modulation des Kontrastes des MR-Signals verwendet werden.

Der erste Hochfrequenz-Puls ist gemäß dieser Ausführungsform ein Hochfrequenz-Puls, welcher für die Erzeugung eines MR-Signals erforderlich ist. Ist die MR-Steuerungssequenz beispielsweise eine Spin-Echo-Sequenz, so kann der erste Hochfrequenz-Puls ein Anregungspuls und/oder ein Refokussierungspuls sein. Der erste Hochfrequenz-Puls ist vorzugsweise dadurch gekennzeichnet, dass bei Verzicht auf den ersten Hochfrequenz-Puls kein MR-Signal erzeugt wird. Für die Erzeugung eines MR-Signals sind typischerweise mehrere Hochfrequenz-Pulse erforderlich. Diesen wird bei der Justierung der MR-Steuerungssequenz vorzugsweise der erste Referenzwert zugeordnet. Der Teil einer MR-Steuerungssequenz, welcher die Erzeugung des MR-Signals bewirkt, kann als Kern der MR-Steuerungssequenz bezeichnet werden.

Der zweite Hochfrequenz-Puls ist gemäß dieser Ausführungsform ein Hochfrequenz-Puls, welcher für die Erzeugung eines MR-Signals verzichtbar ist. Der zweite Hochfrequenz-Puls ist vorzugsweise ein Präparationspuls. Es können für die Modulation des Kontrastes weitere Hochfrequenz-Pulse erforderlich sein, welchen bei der Justierung der MR-Steuerungssequenz vorzugsweise der zweite Referenzwert zugeordnet wird. Die MR-Steuerungssequenz ist vorzugsweise derart aufgebaut, dass die Modulation des Kontrastes vor der Erzeugung des MR-Signals erfolgt und/oder der zweite Hochfrequenz-Puls vor dem ersten Hochfrequenz-Puls ausgespielt wird. Es ist auch eine andere Reihenfolge denkbar.

Diese Ausführungsform des erfindungsgemäßen Verfahrens ermöglicht demnach eine vom Kern einer MR-Steuerungssequenz unabhängige Justierung von Hochfrequenz-Pulsen zur Modulation des Kontrastes. Diese Hochfrequenz-Pulse zur Modulation des Kontrastes sind typischerweise Präparationspulse, insbesondere Sättigungspulse, welche den zweiten Stoff betreffen. Durch die separate Justierung können die Präparationspulse besonders gut an den zweiten Stoff angepasst werden, sodass der resultierende Kontrast der Bilddaten besonders klar ist. Dadurch kann die Qualität der Justierung und der Bilddaten erhöht werden.

Eine Ausführungsform des Verfahrens sieht vor, dass der erste Stoff Wasser umfasst und/oder der zweite Stoff Fett umfasst. Ein Stoff umfasst Wasser, sofern typischerweise die Mehrheit der Kernspins, insbesondere die zum MR-Signal beitragenden, in Wassermolekülen integriert ist. Ein Stoff umfasst Fett, sofern typischerweise die Mehrheit der Kernspins, insbesondere die zum MR-Signal beitragenden, in Fettmolekülen integriert ist. Der erste Stoff kann verschiedenartiges Gewebe, wie beispielsweise Blut, Sehnen, Muskeln, graue Substanz, und/oder weiße Substanz umfassen. Der zweite Stoff kann verschiedenartiges Fett umfassen. Der zweite Stoff kann auch verschiedenartiges Gewebe umfassen.

Umfasst der erste Stoff Wasser, so ermöglicht das erfindungsgemäße Verfahren eine exakte Justierung für verschiedene Gewebe, was eine hohe Bildqualität bewirkt. Umfasst der zweite Stoff Fett, so kann eine Fettsättigung besonders homogen ausgeführt werden. Dies ist besonders vorteilhaft, da zahlreiche MR-Steuerungssequenzen mit und ohne Fettsättigung durchgeführt werden. Das erfindungsgemäße Verfahren ermöglicht aufgrund der präzisen Justierung eine vollständige Fettsättigung.

Eine Ausführungsform des Verfahrens sieht vor, dass der erste Referenzwert und/oder der zweite Referenzwert eine Grundfrequenz umfasst. Diese Ausführungsform ermöglicht eine besonders genaue Bestimmung der Grundfrequenz, also der Frequenz, mit welcher ein Hochfrequenz-Puls ausgegeben wird. Dadurch kann eine resonante Anregung des ersten Stoffes und/oder des zweiten Stoffes besonders gut sichergestellt werden.

Eine Ausführungsform des Verfahrens sieht vor, dass der erste Referenzwert und/oder der zweite Referenzwert eine Referenzspannung umfasst. Die erste Referenzspannung wird typischerweise derart festgelegt, dass der erste Stoff im Mittel um den durch den Hochfrequenz-Puls festgelegten Flipwinkel verkippt wird. Die zweite Referenzspannung wird typischerweise derart festgelegt, dass der zweite Stoff im Mittel um den durch den Hochfrequenz-Puls festgelegten Flipwinkel verkippt wird. Gemäß dieser Ausführungsform können Inhomogenitäten des B1-Feldes berücksichtigt werden. Dies ist insbesondere bei Untersuchungsobjekten und/oder Untersuchungsbereichen vorteilhaft, welche aufgrund dielektrischer Eigenschaften eine räumliche Modulation des B1-Feldes bewirken. Ebenso ist dies vorteilhaft bei lokal auftretenden Stoffen innerhalb des Untersuchungsbereiches. Es ist zudem besonders vorteilhaft, falls an Positionen der lokal auftretenden Stoffe das B1-Feld von dessen Mittelwert im Untersuchungsbereich abweicht. Diese Ausführungsform ermöglicht demnach eine flexible Justierung der MR-Steuerungssequenz.

Des Weiteren geht die Erfindung aus von einem Magnetresonanzgerät mit einer Steuerungseinheit umfassend eine Justierungseinheit. Die Justierungseinheit ist dazu ausgebildet, ein erfindungsgemäßes Verfahren zu einer Justierung einer MR-Steuerungssequenz auszuführen.

Dafür weist die Justierungseinheit typischerweise einen Eingang, eine Prozessoreinheit und einen Ausgang auf. Über den Eingang können der Justierungseinheit eine ursprüngliche MR-Steuerungssequenz und/oder eine Information hinsichtlich eines von der MR-Steuerungssequenz umfassten Hochfrequenz-Pulses und/oder eine Information hinsichtlich des ersten Stoffes und/oder des zweiten Stoffes und/oder des Untersuchungsbereiches bereitgestellt werden. Ebenso können über den Eingang der Justierungseinheit eine B0-Karte und/oder eine B1-Karte bereitgestellt werden. Weitere, im Verfahren benötigte Funktionen, Algorithmen oder Parameter können der Justierungseinheit über den Eingang bereitgestellt werden. Der erste Referenzwert und/oder der zweite Referenzwert und/oder die justierte MR-Steuerungssequenz und/oder weitere Ergebnisse einer Ausführungsform des erfindungsgemäßen Verfahrens können über den Ausgang bereitgestellt werden. Die Justierungseinheit kann in das Magnetresonanzgerät integriert sein. Die Justierungseinheit kann auch separat von dem Magnetresonanzgerät installiert sein. Die Justierungseinheit kann mit dem Magnetresonanzgerät verbunden sein.

Ausführungsformen des erfindungsgemäßen Magnetresonanzgerätes sind analog zu den Ausführungsformen des erfindungsgemäßen Verfahrens ausgebildet. Das Magnetresonanzgerät kann weitere Steuerungskomponenten aufweisen, welche zum Ausführen eines erfindungsgemäßen Verfahrens nötig und/oder vorteilhaft sind. Auch kann das Magnetresonanzgerät dazu ausgebildet sein, Steuerungssignale zu senden und/oder Steuerungssignale zu empfangen und/oder zu verarbeiten, um ein erfindungsgemäßes Verfahren auszuführen. Vorzugsweise ist die Justierungseinheit Teil der Steuerungseinheit des erfindungsgemäßen Magnetresonanzgeräts. Auf einer Speichereinheit der Justierungseinheit können Computerprogramme und weitere Software gespeichert sein, mittels derer die Prozessoreinheit der Justierungseinheit einen Verfahrensablauf eines erfindungsgemäßen Verfahrens automatisch steuert und/oder ausführt.

Ein erfindungsgemäßes Computerprogrammprodukt ist direkt in einer Speichereinheit einer programmierbaren Justierungseinheit eines erfindungsgemäßen Magnetresonanzgeräts ladbar und weist Programmcode-Mittel auf, um ein erfindungsgemäßes Verfahren auszuführen, wenn das Computerprogrammprodukt in der Justierungseinheit ausgeführt wird. Dadurch kann das erfindungsgemäße Verfahren schnell, identisch wiederholbar und robust ausgeführt werden. Das Computerprogrammprodukt ist so konfiguriert, dass es mittels der Justierungseinheit die erfindungsgemäßen Verfahrensschritte ausführen kann. Die Justierungseinheit muss dabei jeweils die Voraussetzungen wie beispielsweise einen entsprechenden Arbeitsspeicher, eine entsprechende Grafikkarte oder eine entsprechende Logikeinheit aufweisen, so dass die jeweiligen Verfahrensschritte effizient ausgeführt werden können. Das Computerprogrammprodukt ist beispielsweise auf einem elektronisch lesbaren Medium gespeichert oder auf einem Netzwerk oder Server hinterlegt, von wo es in den Prozessor einer lokalen Justierungseinheit geladen werden kann, der mit dem Magnetresonanzgerät direkt verbunden oder als Teil des Magnetresonanzgeräts ausgebildet sein kann. Weiterhin können Steuerinformationen des Computerprogrammprodukts auf einem elektronisch lesbaren Datenträger gespeichert sein. Die Steuerinformationen des elektronisch lesbaren Datenträgers können derart ausgestaltet sein, dass sie bei Verwendung des Datenträgers in einer Justierungseinheit eines Magnetresonanzgeräts ein erfindungsgemäßes Verfahren durchführen. Beispiele für elektronisch lesbare Datenträger sind eine DVD, ein Magnetband oder einen USB-Stick, auf welchem elektronisch lesbare Steuerinformationen, insbesondere Software, gespeichert ist. Wenn diese Steuerinformationen (Software) von dem Datenträger gelesen und in eine Steuerungseinheit und/oder Justierungseinheit eines Magnetresonanzgeräts gespeichert werden, können alle erfindungsgemäßen Ausführungsformen der vorab beschriebenen Verfahren durchgeführt werden.

Des Weiteren geht die Erfindung aus von einem elektronisch lesbaren Datenträger, auf dem ein Programm hinterlegt ist, das zu einer Ausführung eines Verfahrens zu einer Justierung einer MR-Steuerungssequenz, vorgesehen ist.

Die Vorteile des erfindungsgemäßen Magnetresonanzgeräts, des erfindungsgemäßen Computerprogrammprodukts und des erfindungsgemäßen elektronisch lesbaren Datenträgers entsprechen im Wesentlichen den Vorteilen des erfindungsgemäßen Verfahrens zu einer Justierung einer MR-Steuerungssequenz, welche vorab im Detail ausgeführt sind. Hierbei erwähnte Merkmale, Vorteile oder alternative Ausführungsformen können ebenso auch auf die anderen beanspruchten Gegenstände übertragen werden und umgekehrt.

Weitere Vorteile, Merkmale und Einzelheiten der Erfindung ergeben sich aus den im Folgenden beschriebenen Ausführungsbeispielen sowie anhand der Zeichnungen.

Es zeigen:
- Fig. 1: ein erfindungsgemäßes Magnetresonanzgerät in einer schematischen Darstellung,
- Fig. 2: ein Ablaufdiagramm einer ersten Ausführungsform eines erfindungsgemäßen Verfahrens,
- Fig. 3: ein Ablaufdiagramm einer zweiten Ausführungsform eines erfindungsgemäßen Verfahrens,
- Fig. 4: eine schematische Darstellung einer zeitlichen Abfolge einer justierten MR-Steuerungssequenz, und
- Fig. 5: ein Beispiel für eine räumliche Verteilung des ersten Stoffes und des zweiten Stoffes in einem Kopf.

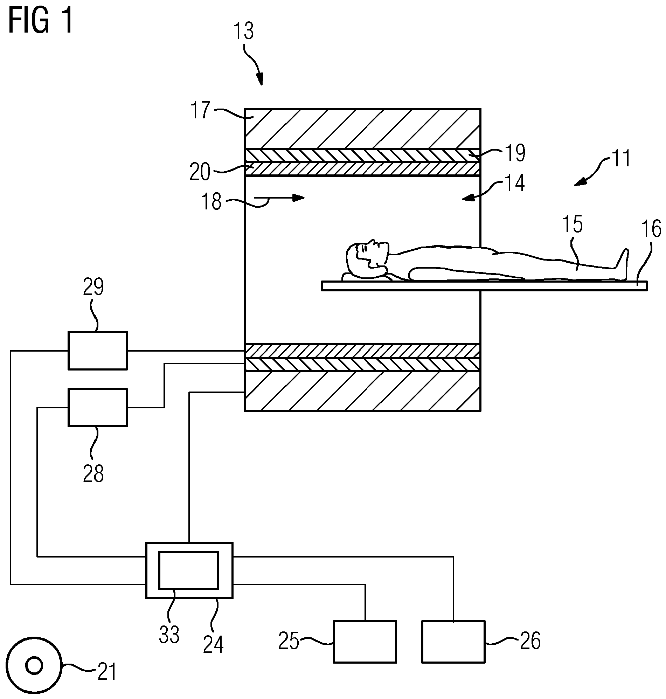

Figur 1 zeigt ein Magnetresonanzgerät 11 zur Ausführung eines erfindungsgemäßen Verfahrens in einer schematischen Darstellung. Das Magnetresonanzgerät 11 umfasst eine von einer Magneteinheit 13 gebildeten Detektoreinheit mit einem Hauptmagneten 17 zu einem Erzeugen eines starken und insbesondere konstanten Hauptmagnetfelds 18. Zudem weist das Magnetresonanzgerät 11 einen zylinderförmigen Patientenaufnahmebereich 14 zu einer Aufnahme eines Untersuchungsobjektes 15, beispielsweise eines Patienten, auf, wobei der Patientenaufnahmebereich 14 in einer Umfangsrichtung von der Magneteinheit 13 zylinderförmig umschlossen ist. Das Untersuchungsobjekt 15 kann mittels einer Patientenlagerungsvorrichtung 16 des Magnetresonanzgeräts 11 in den Patientenaufnahmebereich 14 geschoben werden.

Die Magneteinheit 13 weist weiterhin eine Gradientenspuleneinheit 19 auf, die für eine Ortskodierung während einer Bildgebung verwendet werden. Die Gradientenspuleneinheit 19 wird mittels einer Gradientensteuereinheit 28 angesteuert. Des Weiteren weist die Magneteinheit 13 eine Hochfrequenzantenneneinheit 20, welche im gezeigten Fall als fest in das Magnetresonanzgerät 11 integrierte Körperspule ausgebildet ist, auf. Zudem weist das Magnetresonanzgerät 11 eine Hochfrequenzantennensteuereinheit 29 auf. Die Hochfrequenzantenneneinheit 20 wird von der Hochfrequenzantennensteuereinheit 29 angesteuert und strahlt hochfrequente Hochfrequenz-Pulse in einen Untersuchungsraum, der im Wesentlichen von dem Patientenaufnahmebereich 14 gebildet ist, ein. Die Hochfrequenzantenneneinheit 20 ist durch Ansteuerung mittels der Hochfrequenzantennensteuereinheit 29 zu einer Anregung einer Polarisation, die sich in dem von dem Hauptmagneten 17 erzeugten Hauptmagnetfeld 18 einstellt, ausgebildet.

Zu einer Steuerung des Hauptmagneten 17, der Gradientensteuereinheit 28 und der Hochfrequenzantennensteuereinheit 29 weist das Magnetresonanzgerät 11 eine Steuerungseinheit 24 auf. Die Steuerungseinheit 24 steuert zentral das Magnetresonanzgerät 11, wie beispielsweise das Durchführen von MR-Steuerungssequenzen. Zudem umfasst die Steuerungseinheit 24 eine nicht näher dargestellte Rekonstruktionseinheit zu einer Rekonstruktion von medizinischen Bilddaten, die während der Magnetresonanzuntersuchung erfasst werden. Das Magnetresonanzgerät 11 weist eine Anzeigeeinheit 25 auf. Steuerinformationen wie beispielsweise Steuerungsparameter, sowie rekonstruierte Bilddaten können auf der Anzeigeeinheit 25, beispielsweise auf zumindest einem Monitor, für einen Benutzer angezeigt werden. Zudem weist das Magnetresonanzgerät 11 eine Eingabeeinheit 26 auf, mittels derer Informationen und/oder Steuerungsparameter während eines Messvorgangs von einem Benutzer eingegeben werden können. Die Steuerungseinheit 24 kann die Gradientensteuereinheit 28 und/oder Hochfrequenzantennensteuereinheit 29 und/oder die Anzeigeeinheit 25 und/oder die Eingabeeinheit 26 umfassen.

Die Steuerungseinheit 24 umfasst weiterhin eine Justierungseinheit 33. Die Justierungseinheit 33 ist zudem zu einer Ausführung eines Verfahrens zu einer Justierung einer MR-Steuerungssequenz ausgelegt. Hierzu weist die Justierungseinheit 33 Computerprogramme und/oder Software auf, die direkt in einem nicht näher dargestellten Speichereinheit der Justierungseinheit 33 ladbar sind, mit Programmmitteln, um ein Verfahren zu einer Justierung einer MR-Steuerungssequenz auszuführen, wenn die Computerprogramme und/oder Software in der Justierungseinheit 33 ausgeführt werden. Die Justierungseinheit 33 weist hierzu einen nicht näher dargestellten Prozessor auf, der zu einer Ausführung der Computerprogramme und/oder Software ausgelegt ist. Alternativ hierzu können die Computerprogramme und/oder Software auch auf einem getrennt von der Steuerungseinheit 24 und/oder Justierungseinheit 33 ausgebildeten elektronisch lesbaren Datenträger 21 gespeichert sein, wobei ein Datenzugriff von der Justierungseinheit 33 auf den elektronisch lesbaren Datenträger 21 über ein Datennetz erfolgen kann.

Das dargestellte Magnetresonanzgerät 11 kann selbstverständlich weitere Komponenten umfassen, die Magnetresonanzgeräte 11 gewöhnlich aufweisen. Eine allgemeine Funktionsweise eines Magnetresonanzgeräts 11 ist zudem dem Fachmann bekannt, so dass auf eine detaillierte Beschreibung der weiteren Komponenten verzichtet wird. Das Magnetresonanzgerät 11 ist somit zusammen mit der Justierungseinheit 33 zur Ausführung eines erfindungsgemäßen Verfahrens ausgelegt.

Ein Verfahren zu einer Justierung einer MR-Steuerungssequenz kann auch in Form eines Computerprogrammprodukts vorliegen, das das Verfahren auf die Justierungseinheit 33 implementiert, wenn es auf der Justierungseinheit 33 ausgeführt wird. Ebenso kann ein elektronisch lesbarer Datenträger 21 mit darauf gespeicherten elektronisch lesbaren Steuerinformationen vorliegen, welche zumindest ein solches eben beschriebenes Computerprogrammprodukt umfassen und derart ausgestaltet sind, dass sie bei Verwendung des Datenträgers 21 in einer Justierungseinheit 33 eines Magnetresonanzgeräts 11 das beschriebene Verfahren durchführen.

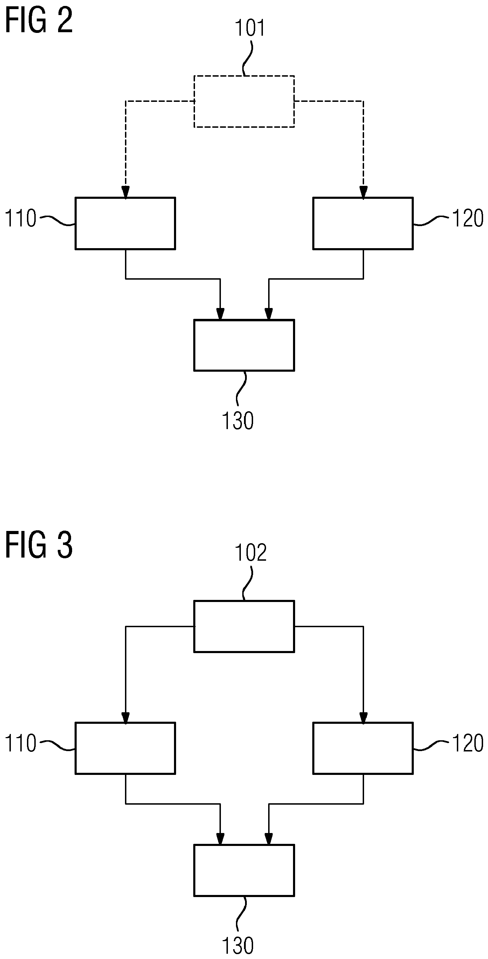

Figur 2 zeigt ein Ablaufdiagramm einer ersten Ausführungsform eines erfindungsgemäßen Verfahrens. Zu Beginn des erfindungsgemäßen Verfahrens liegt typischerweise eine MR-Steuerungssequenz in einer ursprünglichen Fassung vor. Für eine Magnetresonanzuntersuchung eines Untersuchungsbereiches eines Untersuchungsobjektes 15 ist ein Ausspielen einer für den Untersuchungsbereich des Untersuchungsobjektes 15 adaptierten MR-Steuerungssequenz erforderlich, wobei die Adaption eine Justierung der MR-Steuerungssequenz erfordert. Die MR-Steuerungssequenz umfasst zumindest einen ersten Hochfrequenz-Puls und einen zweiten Hochfrequenz-Puls und vom Untersuchungsbereich 15 wird zumindest ein erster Stoff und ein zweiter Stoff umfasst. Die Justierung erfolgt gemäß den Verfahrensschritten 110, 120, 130. Zunächst erfolgt in Verfahrensschritt 110 die Bestimmung eines ersten Referenzwertes für den ersten Hochfrequenz-Puls zur resonanten Anregung eines ersten Stoffes. In Verfahrensschritt 120 erfolgt die Bestimmung eines zweiten Referenzwertes für den zweiten Hochfrequenz-Puls zur resonanten Anregung eines zweiten Stoffes. Die Verfahrensschritte 110 und 120 können zumindest teilweise gleichzeitig oder konsekutiv ausgeführt werden. Die Bestimmung des ersten Referenzwertes in Verfahrensschritt 110 kann eine selektive Anregung des ersten Stoffes umfassen. Die Bestimmung des zweiten Referenzwertes in Verfahrensschritt 120 umfasst eine selektive Anregung des zweiten Stoffes. In Verfahrensschritt 130 erfolgt die Justierung der MR-Steuerungssequenz durch Zuordnung des ersten Referenzwertes zu dem ersten Hochfrequenz-Puls und durch Zuordnung des zweiten Referenzwertes zu dem zweiten Hochfrequenz-Puls. Abschließend wird die justierte MR-Steuerungssequenz vorzugsweise von dem Magnetresonanzgerät 11 in den Untersuchungsbereich ausgespielt, wobei der erste Hochfrequenz-Puls mit dem ersten Referenzwert und der zweite Hochfrequenz-Puls mit dem zweiten Referenzwert parametrisiert wird.

Vor Beginn des Verfahrens kann in dem optionalen Verfahrensschritt 101 die Bestimmung eines allgemeinen Referenzwertes für von der MR-Steuerungssequenz umfasste Hochfrequenz-Pulse für den Untersuchungsbereich erfolgen. Der allgemeine Referenzwert kann dann in Verfahrensschritt 110 und/oder in Verfahrensschritt 120 berücksichtigt werden.

Figur 3 zeigt ein Ablaufdiagramm einer zweiten Ausführungsform eines erfindungsgemäßen Verfahrens. Diese zweite Ausführungsform unterscheidet sich von der in Figur 2 dargestellten ersten Ausführungsform darin, dass das Verfahren mit Verfahrensschritt 102, der Bestimmung eines Frequenzspektrums von vom Untersuchungsbereich umfasster Stoffe beginnt. Das Frequenzspektrum wird bei der Bestimmung des ersten Referenzwertes in Verfahrensschritt 110 und/oder der Bestimmung des zweiten Referenzwertes in Verfahrensschritt 120 berücksichtigt. Die Berücksichtigung des Frequenzspektrums in Verfahrensschritt 110 und/oder Verfahrensschritt 120 erfolgt vorzugsweise derart, dass eine frequenzselektive Messung basierend auf dem Frequenzspektrum erfolgt.

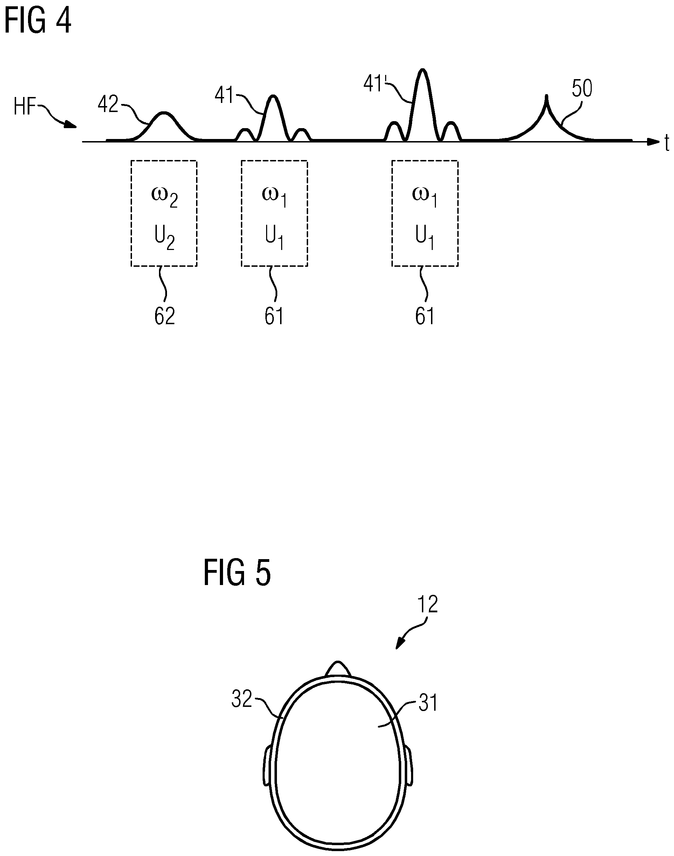

Figur 4 zeigt eine schematische Darstellung einer zeitlichen Abfolge einer justierten MR-Steuerungssequenz. Zumindest ein Teil der zeitlichen Abfolge der von der MR-Steuerungssequenz umfassten Hochfrequenz-Pulse 41, 41', 42 und der dadurch induzierten Hochfrequenz-Signale (MR-Signale) 50 ist entlang des Zeitstahls t schematisch dargestellt. Unter den von der MR-Steuerungssequenz umfassten Hochfrequenz-Pulsen 41, 41', 42 sind deren Referenzspannungen U₁, U₂ und Referenzfrequenzen ω₁, ω₂, und somit deren Referenzwerte 61, 62, angegeben. Die Referenzspannungen U₁, U₂ geben ein Maß zur Skalierung der Amplitude der entsprechenden Hochfrequenz-Pulse 41, 41', 42 an. Die Referenzfrequenzen ω₁, ω₂ geben die Grundfrequenz der entsprechenden Hochfrequenz-Pulse 41, 41', 42 an. Die MR-Steuerungssequenz umfasst die ersten Hochfrequenz-Pulse 41, 41', welche zur Erzeugung eines MR-Signals 50 ausgebildet sind. Die ersten Hochfrequenz-Pulse 41, 41` sind in der dargestellten Form zur Erzeugung eines Spin-Echos ausgebildet. Dabei induziert der erste Hochfrequenz-Puls 41 typischerweise eine Transversalmagnetisierung der Kernspins des ersten Stoffes, indem dieser eine Rotation um der Kernspins um 90° gegenüber den Magnetfeldlinien des Hauptmagnetfelds bewirkt. Der darauf folgende erste Hochfrequenz-Puls 41` erzeugt eine Spiegelung der Transversalmagnetisierung an einer Transversalachse, indem der erste Hochfrequenz-Puls 41` eine Rotation um der Kernspins um 180° bewirkt. Dadurch bildet sich ein Spin-Echo, welches ein Hochfrequenz-Signal, insbesondere ein MR-Signal 50 abstrahlt. Die ersten Hochfrequenz-Pulse 41, 41` sind demnach zur Erzeugung eines MR-Signals 50 ausgebildet.

Die ersten Hochfrequenz-Pulse 41, 41' weisen dabei eine erste Referenzspannung U₁ und eine erste Referenzfrequenz ω₁, welche von dem ersten Referenzwert 61 umfasst werden, auf. Der erste Referenzwert 61 umfassend eine erste Referenzspannung U₁ und eine erste Referenzfrequenz ω₁ ist demnach den ersten Hochfrequenz-Pulsen 41, 41` zugeordnet.

Der zweite Hochfrequenz-Puls 42 wird in der dargestellten MR-Steuerungssequenz zur Modulation des Kontrastes des MR-Signals verwendet. Hierfür kann der zweite Hochfrequenz-Puls 42 in der dargestellten MR-Steuerungssequenz beispielsweise eine Fettsättigung bewirken, sofern der zweite Stoff 32 Fett umfasst. Der zweite Hochfrequenz-Puls 42 wird dabei gemäß dem zweiten Referenzwert 62 ausgespielt, welcher eine zweite Referenzspannung U₂ und eine zweite Referenzfrequenz ω₂ umfasst. Die zweite Referenzfrequenz ω₂ ist typischerweise derart gewählt, dass die Differenz zwischen der zweiten Referenzfrequenz ω₂ und der ersten Referenzfrequenz ω₁ der chemischen Verschiebung zwischen dem zweiten Stoff 32 und dem ersten Stoff 31 entspricht. Die Bestimmung der zweiten Referenzspannung U₂ erfolgt erfindungsgemäß unter Berücksichtigung der räumlichen Verteilung des zweiten Stoffes 32 und vorzugsweise unter Berücksichtigung einer räumlichen Verteilung einer Amplitude eines von der Hochfrequenzantenneneinheit 20 erzeugten Hochfrequenz-Pulses. Die Bestimmung der ersten Referenzspannung U₁ erfolgt vorzugsweise unter Berücksichtigung der räumlichen Verteilung des ersten Stoffes 31 und/oder einer räumlichen Verteilung einer Amplitude eines von der Hochfrequenzantenneneinheit 20 erzeugten Hochfrequenz-Pulses.

Figur 5 zeigt ein Beispiel für eine räumliche Verteilung des ersten Stoffes 31 und des zweiten Stoffes 32 in einem Kopf. Der Untersuchungsbereich 12 entspricht dabei vorzugsweise dem gesamten Kopf. Der erste Stoff 31 umfasst vorzugsweise Wasser. Der zweite Stoff 32 umfasst vorzugsweise Fett. Bei der Anregung eines Stoffes werden vorzugsweise Kernspins mit einem definierten gyromagnetischen Verhältnis, typischerweise Wasserstoffprotonen, welche von diesem Stoff umfasst werden, angeregt, insbesondere moduliert. Figur 5 visualisiert eine stark lokalisierte Anordnung des ersten Stoffes 31 und des zweiten Stoffes 32. Da die Ausbreitung von Hochfrequenzwellen insbesondere durch kugelförmige Anordnungen, wie beispielsweise durch den dargestellten Kopf, beeinflusst wird, kann der Hochfrequenz-Puls eine positionsabhängige Amplitude aufweisen. Dies führt insbesondere in der Mitte des Kopfes, also im Bereich des ersten Stoffes 31, zu einem höheren Hochfrequenzsignal als am Rand des Kopfes, also im Bereich des zweiten Stoffes 32. Bei der Bestimmung des ersten Referenzwertes 61 und/oder des zweiten Referenzwertes 62 kann eine räumliche Verteilung des ersten Stoffes 31 und/oder des zweiten Stoffes 32 berücksichtigt werden.

Obwohl die Erfindung im Detail durch die bevorzugten Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den durch die Ansprüche definierten Schutzumfang der Erfindung zu verlassen.

## Patentansprüche

1. Verfahren zu einer Justierung einer MR-Steuerungssequenz umfassend einen ersten Hochfrequenz-Puls (41, 41') und einen zweiten Hochfrequenz-Puls (42) für eine Magnetresonanzuntersuchung eines Untersuchungsbereiches (12) umfassend einen ersten Stoff (31) und einen zweiten Stoff (32) eines Untersuchungsobjektes (15) mittels der MR-Steuerungssequenz gemäß den folgenden Verfahrensschritten:
- Bestimmung eines ersten Referenzwertes (61) in Form einer ersten Referenzfrequenz und/oder einer ersten Referenzspannung für den ersten Hochfrequenz-Puls (41, 41') zur resonanten Anregung des ersten stoffes (31), wobei die erste Referenzfrequenz eine Grundfrequenz des ersten Hochfrequenz-Pulses und die erste Referenzspannung ein Maß zur Skalierung einer Amplitude des ersten Hochfrequenz-Pulses angibt,
- Bestimmung eines zweiten Referenzwertes (62) in Form einer zweiten Referenzfrequenz und/oder einer zweiten Referenzspannung für den zweiten Hochfrequenz-Puls (42) zur resonanten Anregung des zweiten stoffes (32), wobei die zweite Referenzfrequenz eine Grundfrequenz des zweiten Hochfrequenz-Pulses und die zweite Referenzspannung ein Maß zur Skalierung einer Amplitude des zweiten Hochfrequenz-Pulses angibt, wobei die Bestimmung des zweiten Referenzwertes (62) eine selektive Anregung umfassend eine resonante Anregung des zweiten Stoffes (32) und eine Bestimmung einer räumlichen Verteilung des zweiten Stoffes (32) basierend auf der selektiven Anregung des zweiten Stoffes (32) umfasst und unter Berücksichtigung der räumlichen Verteilung des zweiten Stoffes (32) und einer räumlichen Verteilung eines B0-Feldes und/oder eines B1-Feldes erfolgt,
- Justierung der MR-Steuerungssequenz durch Zuordnung des ersten Referenzwertes (61) zu dem ersten Hochfrequenz-Puls (41, 41') und Zuordnung des zweiten Referenzwertes (62) zu dem zweiten Hochfrequenz-Puls (42).

2. Verfahren nach Anspruch 1, umfassend eine Bestimmung eines Frequenzspektrums von vom Untersuchungsbereich (12) umfasster Stoffe (31, 32), wobei das Frequenzspektrum bei der Bestimmung des ersten Referenzwertes (61) und/oder des zweiten Referenzwertes (62) berücksichtigt wird.

3. Verfahren nach einem der vorangehenden Ansprüche, umfassend eine Bestimmung eines allgemeinen Referenzwertes für von der MR-Steuerungssequenz umfasste Hochfrequenz-Pulse (41, 41', 42) für den Untersuchungsbereich (12), wobei der allgemeine Referenzwert für den gesamten Untersuchungsbereich (12) einheitlich ist und bei der Bestimmung des ersten Referenzwertes (61) und/oder des zweiten Referenzwertes (62) berücksichtigt wird.

4. Verfahren nach einem der vorangehenden Ansprüche,
wobei der erste Hochfrequenz-Puls (41, 41') zur Erzeugung eines MR-Signals (50) und der zweite Hochfrequenz-Puls (42) zur Modulation des Kontrastes des MR-Signals verwendet werden.

5. Verfahren nach einem der vorangehenden Ansprüche,
wobei der erste Stoff (31) Wasser umfasst und/oder der zweite Stoff (32) Fett umfasst.

6. Verfahren nach einem der vorangehenden Ansprüche,
wobei der erste Referenzwert (61) die erste Referenzfrequenz und/oder der zweite Referenzwert (62) die zweite Referenzfrequenz umfasst.

7. Verfahren nach einem der vorangehenden Ansprüche, wobei der erste Referenzwert (61) die erste Referenzspannung und/oder der zweite Referenzwert (62) die zweite Referenzspannung umfasst.

8. Magnetresonanzgerät (11) mit einer Steuerungseinheit (24) umfassend eine Justierungseinheit (33), die zu einer Ausführung eines Verfahrens zu einer Justierung einer MR-Steuerungssequenz nach einem der vorangehenden Ansprüche ausgelegt ist.

9. Computerprogrammprodukt, welches ein Programm umfasst und direkt in einen Speicher einer programmierbaren Justierungseinheit (33) eines Magnetresonanzgeräts nach Anspruch 8 ladbar ist, mit Programmmitteln, um ein Verfahren zu einer Justierung einer MR-Steuerungssequenz nach einem der Ansprüche 1 bis 7 auszuführen, wenn das Programm in der Justierungseinheit (33) ausgeführt wird.

10. Elektronisch lesbarer Datenträger (21), auf dem ein Programm hinterlegt ist, das derart ausgestaltet ist, dass das Programm bei Verwendung des Datenträgers (21) in einer Justierungseinheit (33) eines Magnetresonanzgeräts nach Anspruch 8 das Verfahren zu einer Justierung einer MR-Steuerungssequenz nach einem der Ansprüche 1 bis 7 durchführt.

## Claims

1. Method for calibrating an MR control sequence comprising a first radio-frequency pulse (41, 41') and a second radio-frequency pulse (42) for a magnetic resonance examination of an examination region (12) comprising a first substance (31) and a second substance (32) of an examination object (15) by means of the MR control sequence in accordance with the following method steps:
- determination of a first reference value (61) in the form of a first reference frequency and/or a first reference voltage for the first radio-frequency pulse (41, 41') for resonant excitation of the first substance (31), wherein the first reference frequency specifies a basic frequency of the first radio-frequency pulse and the first reference voltage specifies a measure for scaling an amplitude of the first radio-frequency pulse,
- determination of a second reference value (62) in the form of a second reference frequency and/or a second reference voltage for the second radio-frequency pulse (42) for resonant excitation of the second substance (32), wherein the second reference frequency specifies a basic frequency of the second radio-frequency pulse and the second reference voltage specifies a measure for scaling an amplitude of the second radio-frequency pulse,
wherein the determination of the second reference value (62) comprises a selective excitation comprising a resonant excitation of the second substance (32) and a determination of a spatial distribution of the second substance (32) based on the selective excitation of the second substance (32) and takes place taking into account the spatial distribution of the second substance (32) and a spatial distribution of a BO field and/or a B1 field,
- calibration of the MR control sequence by assignment of the first reference value (61) to the first radio-frequency pulse (41, 41') and assignment of the second reference value (62) to the second radio-frequency pulse (42).

2. Method according to claim 1,
comprising a determination of a frequency spectrum of substances (31, 32) comprised by the examination region (12), wherein the frequency spectrum is taken into account in the determination of the first reference value (61) and/or of the second reference value (62).

3. Method according to one of the preceding claims,
comprising a determination of a general reference value for radio-frequency pulses (41, 41', 42) for the examination region (12) comprised by the MR control sequence, wherein the general reference value is uniform for the entire examination region (12) and is taken into account in the determination of the first reference value (61) and/or of the second reference value (62).

4. Method according to one of the preceding claims,
wherein the first radio-frequency pulse (41, 41') is used for creation of an MR signal (50) and the second radio-frequency pulse (42) is used for modulation of the contrast of the MR signal.

5. Method according to one of the preceding claims,
wherein the first substance (31) comprises water and/or the second substance (32) comprises fat.

6. Method according to one of the preceding claims,
wherein the first reference value (61) comprises the first reference frequency and/or the second reference value (62) comprises the second reference frequency.

7. Method according to one of the preceding claims,
wherein the first reference value (61) comprises the first reference voltage and/or the second reference value (62) comprises the second reference voltage.

8. Magnetic resonance device (11) with a control unit (24) comprising a calibration unit (33), which is designed for carrying out a method for calibrating an MR control sequence according to one of the preceding claims.

9. Computer program product, which comprises a program and is able to be loaded directly into a memory of a programmable calibration unit (33) of a magnetic resonance device according to claim 8, with program means for carrying out a method for calibrating an MR control sequence according to one of claims 1 to 7, when the program is executed in the calibration unit (33) .

10. Electronically-readable data medium (21), on which a program is stored, which is embodied such that, when the data medium (21) is stored in a calibration unit (33) of a magnetic resonance device according to claim 8, the program carries out the method for calibrating an MR control sequence according to one of claims 1 to 7.

## Revendications

1. Procédé de réglage d'une séquence de commande RM comprenant une première impulsion (41, 41') de haute fréquence et une deuxième impulsion (42) de haute fréquence pour un examen par résonnance magnétique d'une partie (12) à examiner comprenant une première matière (31) et une deuxième matière (32) d'un objet (15) à examiner au moyen de la séquence de commande RM selon les stades de procédé suivants :
- détermination d'une première valeur (61) de référence sous la forme d'une première fréquence de référence et/ou d'une première tension de référence pour la première impulsion (41, 41') de haute fréquence pour l'excitation en résonnance de la première matière (31), dans lequel la première fréquence de référence indique une fréquence fondamentale de la première impulsion de haute fréquence et la première tension de référence une mesure pour la mise à l'échelle d'une amplitude de la première impulsion de haute fréquence,
- détermination d'une deuxième valeur (62) de référence sous la forme d'une deuxième fréquence de référence et/ou d'une deuxième tension de référence pour la deuxième impulsion (42) de haute fréquence pour l'excitation en résonnance de la deuxième matière (32), dans lequel la deuxième fréquence de référence indique une fréquence fondamentale de la deuxième impulsion de haute fréquence et la deuxième tension de référence une mesure pour la mise à l'échelle d'une amplitude de la deuxième impulsion de haute fréquence,
dans lequel la détermination de la deuxième valeur (62) de référence comprend une excitation sélective comprenant une excitation en résonnance de la deuxième matière (32) et une détermination d'une répartition dans l'espace de la deuxième matière (32) sur la base de l'excitation sélective de la deuxième matière (32) et en tenant compte de la répartition dans l'espace de la deuxième matière (32) et d'une répartition dans l'espace d'un champ BO et/ou d'un champ B1,
- réglage de la séquence de commande RM par association de la première valeur (61) de référence à la première impulsion (41, 41') de haute fréquence et association de la deuxième valeur (62) de référence à la deuxième impulsion (42) de haute fréquence.

2. Procédé suivant la revendication 1,
comprenant une détermination d'un spectre de fréquence de matières (31, 32) impliquées par la partie (12) en examen, dans lequel on prend en compte le spectre de fréquence lors de la détermination de la première valeur (61) de référence et/ou de la deuxième valeur (62) de référence.

3. Procédé suivant l'une des revendications précédentes,
comprenant une détermination d'une valeur de référence générale pour les impulsions (41, 41', 42) de haute fréquence impliquées par la séquence de commande RM pour la partie (12) en examen, dans lequel la valeur de référence générale est unitaire pour toute la partie (12) en examen et est prise en compte lors de la détermination de la première valeur (61) de référence et/ou de la deuxième valeur (62) de référence.

4. Procédé suivant l'une des revendications précédentes,
dans lequel on utilise la première impulsion (41, 41') de haute fréquence pour la production d'un signal (50) RM et la deuxième impulsion (42) de référence pour la modulation du contraste du signal RM.

5. Procédé suivant l'une des revendications précédentes,
dans lequel la première matière (31) comprend de l'eau et/ou la deuxième matière (32) comprend de la graisse.

6. Procédé suivant l'une des revendications précédentes,
dans lequel la première valeur (61) de référence comprend la première fréquence de référence et/ou la deuxième valeur (62) de référence comprend la deuxième fréquence de référence.

7. Procédé suivant l'une des revendications précédentes,
dans lequel la première valeur (61) de référence comprend la première tension de référence et/ou la deuxième valeur (62) de référence comprend la deuxième tension de référence.

8. Appareil (11) de résonnance magnétique ayant une unité (24) de commande comprenant une unité (33) de réglage, qui est conçue pour l'exécution d'un procédé de réglage d'une séquence de commande RM suivant l'une des revendications précédentes.

9. Produit de programme d'ordinateur, qui comprend un programme et qui peut être chargé directement dans la mémoire d'une unité (33) de réglage programmable d'un appareil de résonnance magnétique suivant la revendication 8, comprenant des moyens de programme, pour exécuter un procédé de réglage d'une séquence de commande RM suivant l'une des revendications 1 à 7, lorsque le programme est exécuté dans l'unité (33) de réglage.

10. Support (21) de données, déchiffrable par ordinateur, sur lequel est mis en mémoire un programme, qui est conformé de manière à ce que le programme exécute, lors de l'utilisation du support (21) de données dans une unité (33) de réglage d'un appareil de résonnance magnétique suivant la revendication 8, le procédé de réglage d'une séquence de commande RM suivant l'une des revendications 1 à 7.
